# EUROPÄISCHE PATENTANMELDUNG

(11) **EP 0 803 318 A1**
(43) Veröffentlichungstag der Anmeldung: **29.10.1997**
(21) Anmeldenummer: 97103757.7
(22) Anmeldetag: 06.03.1997
(51) Int. Cl.: B23Q 3/155, H05K 3/00

(54) **Werkzeugmagazin-Anordnung und Wechselvorrichtung für Leiterplatten-Koordinaten-Bohrmaschinen**

(30) Priorität: 23.04.1996 DE 19616215
(71) Anmelder: KLG Electronic Gesellschaft mbH, D-87600 Kaufbeuren (DE)
(72) Erfinder: Seitz, Helmut, 87600 Kaufbeuren (DE); Petrick, Jens-Peter, 86825 Bad Wörishofen (DE)
(74) Vertreter: Ruschke, Hans Edvard, Dipl.-Ing.

(57) **Zusammenfassung**

Leiterplatten-Koordinatenbohrmaschine (1) mit einem Werkstück-Spanntisch (5), einer in Z-Richtung verfahrbaren Bohrspindel, wobei die Bohrspindel und der Werkstück-Spanntisch relativ zueinander in X-, Y- und Z-Richtung verfahrbar sind, einem Werkzeug-Wechselsystem, und wenigstens einem austauschbaren Werkzeug-Speichermagazin (7) vorzugsweise an einem der Seitenränder des Werkstück-Spanntisches (5). Um wesentlich mehr Bohr- und Fräswerkzeuge an der Bohrmaschine verfügbar zu halten, als bisher in diesem Zusammenhang möglich ist, ohne eine wesentliche Veränderung der LP-Bohrmaschine vornehmen zu müsen, wird vorgeschlagen:
a) eine Aufreihung von zusätzlichen Werkzeug-Speichermagazinen (6) oder Magazin-Speicherreihen in unmittelbarer Nähe des in eine Magazin-Wechselposition eingefahrenen Werkstück-Spanntisches (5), und
b) eine Vorrichtung zur Verschiebung des aktuellen Magazins (7) an der Wekstück-Spannplatte (5) in einem freien Platz der Magazin-Speicherreihe (6) und zum Einfahren eines zusätzlichen neuen Magazins in die Magazinaufnahme (50, 74, 80) des Spanntisches.

## Beschreibung

Die vorliegende Erfindung betrifft eine Werkzeugmagazin-Anordnung und -Wechselvorrichtung für ein Werkzeugwechselsystem von Leiterplatten-Koordinatenbohrmaschinen nach dem Oberbegriff des Patentanspruchs 1.

Bei der Herstellung von elektronischen Baugruppen für alle möglichen Anwendungsfälle werden sehr häufig gedruckte Schaltungen auf Leiterplatten verwendet, wobei aktive elektronische Komponenten in entsprechend angeordnete Bohrungen dieser Leiterplatte/gedruckten Schaltung eingesetzt und dort verlötet werden. Hierfür müssen also die Leiterplatten im Zuge ihrer oft in seht hohen Stückzahlen erfolgenden Herstellung mit diesen Bohrungen versehen werden, die je nach Art der Leiterplatte in verschiedenen Durchmessern und/oder Tiefen (z. B. bei Mehrlagenplatten) und in Stückzahlen von bis zu einigen 1000 pro Leiterplatte benötigt werden. Es liegt auf der Hand, daß eine wirtschaftliche Fertigung derartiger Leiterplatten nur im Rahmen einer stark durchrationlisierten Produktion erfolgen kann.

Zu diesem Zweck werden Koordinatenbohrmaschinen eingesetzt, die mit einer oder mehreren Bohrstationen entsprechend viele Leiterplatten(-stapel) gleichzeitig bearbeiten. In Abhängigkeit von der Standzeit eines einzelnen Bohrers und von den verschiedenen Bohrungsdurchmessern etc. müssen je nach vorgesehenem Arbeitsablauf die Bohrwerkzeuge ausgewechselt werden.

LP-Koordinatenbohrmaschinen werden in vielen verschiedenen Ausgestallungen angeboten: Häufig werden sie mit einem in einer Richtung, etwa in der Y-Achse verschieblichen Werkstückschlitten (Leiterplatten-/Werkstück-Spannplatte) versehen, der über geeignete Luftlager beispielsweise auf einer Sockelplatte aus Granit extrem reibungsarm verschiebbar ist. Die Verschiebung in Richtung, der X-Achse erfolgt im Falle des nachstehend in Rede stehenden Ausführungsbeispiels mit Hilfe einer über diesem Tisch angeordneten balkenartigen Traverse, auf der wiederum über Luftlager ein in Querrichtung verschiebbarer Schlitten angeordnet ist. Dieser Schlitten trägt die häufig wie ein zylindrisches Bauteil ausgebildete(n) Bohrspindeleinheit(en), die zur Erzeugung der Bohrtiefenverstellung in Z-Richtung diese entweder selbst ausführen oder auf einem eigenen Schlitten (auf dem Querschlitten) angeordnet ist (sind) oder selbst in Richtung der Z-Achse axial verschieblich angeordnet ist (sind), z. B. mit Hilfe von geeigneten Luftlagern auf dem Querschlitten. Bei den hier eingesetzten Bohrspindeleinheiten handelt es sich um standardisierte, d. h. in verschiedenen Größen auf dem Markt erhältliche zylinderförmige Baugruppen, die den Antrieb und die Lagerung für die mit sehr hoher Drehzahl antreibbare eingentliche Bohrspindel mit der darin vorgesehenen Spannzange enthalten. Auf diese Details aus dem Stand der Technik wird im Rahmen der vorliegenden Anmeldung nicht eingegangen, da sie alle zum Kenntnisstand des einschlägigen Fachmannes gehören.

Bei derartigen Koordinatenbohrmaschinen für die Herstellung von Leiterplatten sind bereits unterschiedliche Werkzeugwechselvorrichtungen angegeben worden, die sich aus Magazinen bedienen. So ist es beispielsweise bekannt, am stirnseitigen Ende des Spanntisches, quasi als Verlängerung desselben in Richtung auf die Bedienungsperson, ein oder zwei gegebenenfalls manuell auswechselbare Magazine mit nebeneinander aufgereihten Bohr- oder Bearbeitungswerkzeugen vorzusehen.

Beispielsweise zeigt die EP-287 071 A2 ein Werkzeugwechselsystem, bei dem eine Reihe von Bohr- und Fräswerkzeugen in einem Speichermagazin am vorderen Rand der in Y Richtung verschieblichen Werkstück-Spannplatte der Leiterplatten-Bohrmaschine in Halterungen oder Buchsen achsparallel zur Bohrspindel der Bohrspindeleinheit eingesetzt sind. Zur Entnahme eines solchen Werkzeuges aus dem Magazin fährt die leere Spannzange der Bohrspinden über das ausgewählte Werkzeug ein, erfaßt den Werkzeugschaft im Bereich seines oberen Endes und zieht das Werkzeug aus dem Magazin heraus. Anschließend fährt die Bohrspindel mit dem in der Spannzange gehaltenen Werkzeugschaft in eine sogenannte Spannstation in der Nähe des Magazins axial ein, wobei sich eine Relativverschiebung zwischen dem Werkzeugschaft und der Spannzange der Bohrspindel ergibt und die axiale Lage des Werkzeuges in der Bohrspindel festgelegt wird. Anschließend fährt die Bohrspindel zu den Werkstücken auf der Werkstück-Spannplatte, um die Leiterplatten zu bearbeiten. Zur Bearbeitung der Werkstücke werden im Automatikbetrieb der Leiterplatten-Bohrmaschine eine Vielzahl verschiedener Bohr- oder Fräswerkzeuge benötigt, die sich in dem Werkzeugmagazin befinden. Auch auf diese oder ähnliche bekannte Einzelheiten von verschiedenen Werkzeugwechselsystemen von Leiterplatten-Bohrmaschinen wird im Rahmen der vorliegenden Erfindung nicht eingegangen.

Mit der zunehmenden Komplexität der Leiterplatten ergibt sich ein steigender Bedarf an verfügbaren Bohr- und Fräswerkzeugen beim Automatikbetrieb der Leiterplatten-Bohrmaschine. Diesem steigenden Bedarf wurde bisher mit einer Vergrößerung der schon verwendeten Werkzeugmagazine entsprochen. Zukünftig ist jedoch ein noch wesentlich größerer Bedarf an verfügbaren Werkzeugen für den Automatikbetrieb einer LP-Bohrmaschine zu erwarten. Eine wesentliche Vergrößerung der Werkzeugmagazine z. B. am vorderen Rand des LP-Aufspanntisches führt jedoch zu erheblichen Nachteilen im Hinblick auf die Auslegung der Leiterplatten-Bohrmaschine, da besonders große Magazine am Werkstückschlitten (Werkstück-Spannplatte) bei unverändertem Schlittenhub entweder zu einer Verkürzung des für das Bohren der Leiterplatten nutzbaren Schlittenhubes bzw. zu einer Verkleinerung der Tischarbeitsfläche führen oder die Notwendigkeit einer Vergrößerung der Leiterplatten-Bohrmaschine selbst nach sich ziehen, weil der Schlittenhub größer werden müßte, um jeden Magazinplatz des dann stark vergrößerten Magazins am Rande des Werkstückschlittens zu erreichen.

Eine Aufgabe der Erfindung ist es daher, eine Leiterplatten-Bohrmaschine derart zu gestalten, daß eine solche Vielzahl zusätzlicher Bohr- und Fräswerkzeuge für den Wechsel in die Bohrspindeleinheit verfügbar ist, die wesentlich über die bisherige Zahl an im Magazin verfügbaren Bohr- und Fräswerkzeugen hinausgeht. Mit der Gesamtheit der verfügbaren Bohr- und Fräswerkzeuge soll es möglich sein, daß die Leiterplatten-Bohrmaschine eine Vielzahl verschiedenartiger Aufträge z. B. im Rahmen von "mannlosen" Nachtschichten abarbeiten kann, ohne daß die Maschine gestoppt werden muß, um Werkzeuge oder das ganze Magazin manuell auszuwechseln.

Zur Aufgabe der Erfindung gehört es auch, daß die Verfügbarkeit einer Vielzahl weiterer Werkzeuge keine wesentliche Veränderung der Bauform der Leiterplatten-Bohrmaschine erforderlich machen soll. Weiterhin soll die Verfügbarkeit einer Vielzahl weiterer Werkzeuge mit Maßnahmen erreicht werden, die an bereits vorhandenen Leiterplatten-Bohrmaschinen vorgesehen werden können, ohne daß diese mit größerem Aufwand modifiziert werden müßten. Diese Maßnahmen zur Erhöhung der Verfügbarkeit der Bohr- und Fräswerkzeuge soll weder den nutzbaren Schlittenhub verkürzen, noch deren Tischarbeitsfläche verkleinern oder die Werkzeugmaschine wesentlich vergrößern.

Diese Aufgaben werden mit den Merkmalen des kennzeichnenden Teils des Anspruchs 1 gelöst. Weitere Ausführungsformen sind in den Unteransprüchen beschrieben.

Ein Vorteil der vorliegenden Erfindung ist es, daß im Automatik-Betrieb der Leiterplatten-Bohrmaschine ein wesentlich größerer Werkzeugvorrat verfügbar ist, als es nach dem Stand der Technik möglich ist. Durch das Bereithalten einer Reihe von Magazinen, die jeweils in eine Lage z. B. am vorderen Rand der Werkstückspannplatte gebracht werden können, wo die Bohrspindeleinheit Zugriff auf jedes Werkzeug des dort befindlichen Magazins hat, kann eine wesentlich über die bisher übliche Standardbestückung an Werkzeugen hinausgehende Zahl von Werkzeugen für die Bohrspindel bereitgestellt werden. Dadurch ist die Leiterplatten-Bohrmaschine in der Lage, eine Vielzahl verschiedener Aufträge oder Bearbeitungsmöglichkeiten der Leiterplatten innerhalb eines automatischen Betriebslaufs durchzuführen, ohne daß die Werkzeugmaschine gestoppt oder manuell bedient werden müßte.

Ein weiterer Vorteil der Erfindung liegt darin, daß von der erfindungsgemäßen Werkzeugmagazin-Anordnung und -Wechselvorrichtung bisher nicht genutzter Raum um die Bohrmaschine herum und insbesondere in der Nähe bzw. oberhalb der Werkstück-Spannplatte verwendet wird, so daß die zusätzlich vorgesehenen Magazine keine konstruktive Vergrößerung der Leiterplatten-Bohrmaschine selbst erforderlich machen. Weiterhin ist auch keine größere Modifikation bereits im Einsatz befindlicher Werkzeugmaschinen nötig, um die erfindungsgemäße Magazin-Anordnung und -Wechseleinrichtung nachträglich in diese einzubauen. Der durch die Erfindung ausgenutzte Raum im Bereich der Werkstückspannplatte kann oberhalb oder vor oder seitlich von der Werkstück-Spannplatte mit daran angeordnetem "aktuellen" Werkzeugspeichermagazin vorgesehen sein; dies bedeutet, daß eine Reihe oder Abfolge von "zusätzlichen" Werkzeug-magazinen z. B. in einer zur Werkstück-Spannplatte parallelen Ebene verhältnismäßig dicht oberhalb oder vor derselben angeordnet wird - oder in einer dazu vertikalen oder horizontalen Ebene vor oder seitlich von der LP-Bohrmaschine. Auch ist es denkbar, die "zusätzlichen" Magazine auf einer gekrümmten und/oder in sich geschlossenen Bahn, z. B. im Rahmen eines Kettenförderers, in der Nähe der Magazinwelchselposition(en) der Werkstück-Spannplatte anzuordnen. Nach Erreichen dieser Wechselposition(en) muß dann die Wechselvorrichtung (z.B. eine einfache Hubmechanik) das 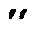 aktuelle*"* Magazin von der Werkstück-Spannplatte in einen leeren Platz des Kettenförderers überführen und anschließend ein neues Magazin dem Kettenförderer entnehmen und auf den Platz an der Werkstück-Spannplatte setzen.

Im folgenden wird ein Ausführungsbeispiel der vorliegenden Erfindung unter Bezugnahme auf die beigefügten Figuren beschrieben. Es zeigen:
- Fig. 1: eine schematische Seitenansicht einer Leiterplatten-Bohrmaschine mit einer Ausführungsform der erfindungsgemäßen Magazin-Anordnung und - Wechseleinrichtung,
- Fig. 2: eine schematische Vorderansicht einer Leiterplatten-Bohrmaschine der Fig.1 mit einer Ausführungsform der erfindungsgemäßen Magazin-Anordnung und Wechseleinrichtung,
- Fig. 3: eine Ansicht der Ausführungsform der Fig. 1 etwa längs Linie 3-3 derselben, wobei ein Magazin in der Vorratsebene und das aktuelle Magazin auf der Werkstück-Spannplatte dargestellt ist,
- Fig. 4: eine Teil-Schnittansicht ähnlich der Fig. 3, wobei allerdings nur die auf der Grundplatte verschieblich angeordnete Werkstück-Spannplatte mit der Hubmechanik der Magazin-Wechselanordnung gezeigt ist,
- Fig. 5: eine Ansicht einer seitlichen Stirnfläche eines Werkzeugmagazins mit der jeweiligen Griffleiste,
- Fig. 6: einen Schnitt entlang der Linie 6-6 aus Fig.4 und

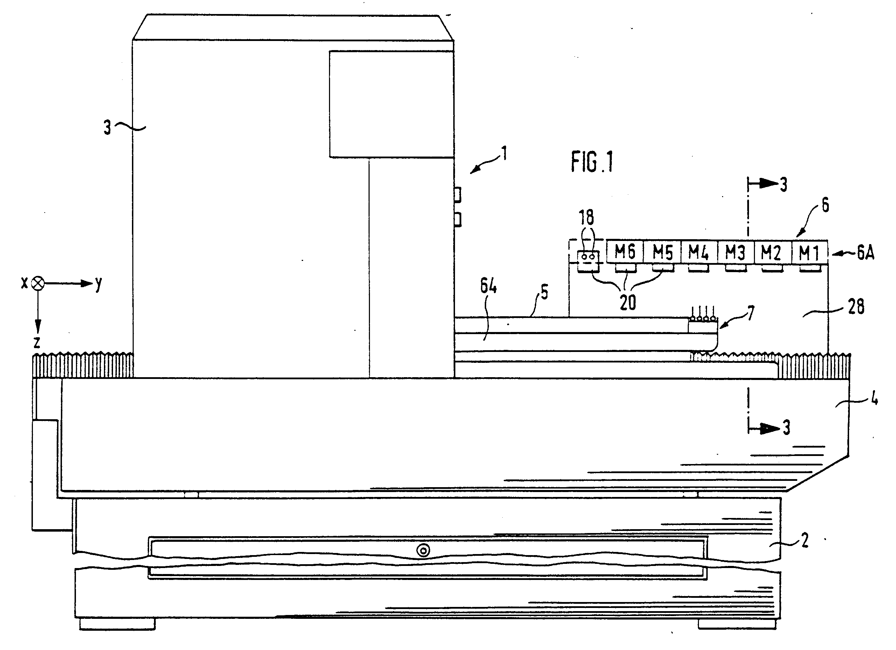

Fig. 1 zeigt eine Ausführungsform einer Leiterplatten-Bohrmaschine 1 mit einem Grundgestell 2, einer Grundplatte 4 und einer auf dieser angeordneten Werkstück-Spannplatte 5, die in Y-Richtung axial verschieblich ist. Die in üblicher Weise in Z- und X-Richtung (siehe das Koordinatenkreuz in Fig. 1) verstellbare(n) Bohrspindeleinheit(en) zum Bohren der auf der Werkstück-Spannplatte anzuordnenden Leiterplattenpakete ist (sind) nicht näher dargestellt, da sie von einem Gehäuse 3 umschlossen ist (sind), wie es häufig in der Technik verwendet wird. Weiterhin ist ein Werkzeugmagazin 7 wie bei LP-Bohrmaschinen häufig üblich am vorderen Ende der Werkstück-Spannplatte 5 angeordnet, wobei dieses Magazin 7 im folgenden allgemein als "aktuelles" Werkzeugmagazin und mit dem Bezugszeichen 7 bezeichnet wird. Fig. 1 zeigt weiterhin sieben weitere Werkzeugmagazine M1 bis M6, die auf einer Vorratsebene relativ dicht oberhalb der Werkstück-Spannplatte 5 gelegen sind. Diese werden im folgenden auch als "zusätzliche" Werkzeugmagazine und bisweilen auch mit dem Bezugszeichen 6 bezeichnet.

Die Art und Weise, in der ein Werkzeugwechsel zwischen dem aktuellen Magazin 7 am vorderen Rand der Werkstück-Spannplatte 5 (die auf dem Y-Schlitten 64 befestigt ist) und der/den Bohrspindeleinheit(en) im Gehäuse 3 geschieht, ist in der Technik hinlänglich bekannt, so daß im Rahmen der vorliegenden Anmeldung nicht näher darauf eingegangen zu werden braucht. Grundsätzlich erfolgt der Werkzeugwechsel jedoch in der Weise, daß das aktuelle Magazin 7 in Y-Richtung bis unter die nicht näher dargestellte Bohrspindeleinheit(en) im Gehäuse 3 verschoben wird, wonach die Bohrspindeleinheit(en) das bis dahin benutzte Werkzeug in einem freien Platz im Magazin 7 ablegt (ablegen) und ein neues Werkzeug von einem anderen Magazinplatz desselben Magazins entnimmt (entnehmen).

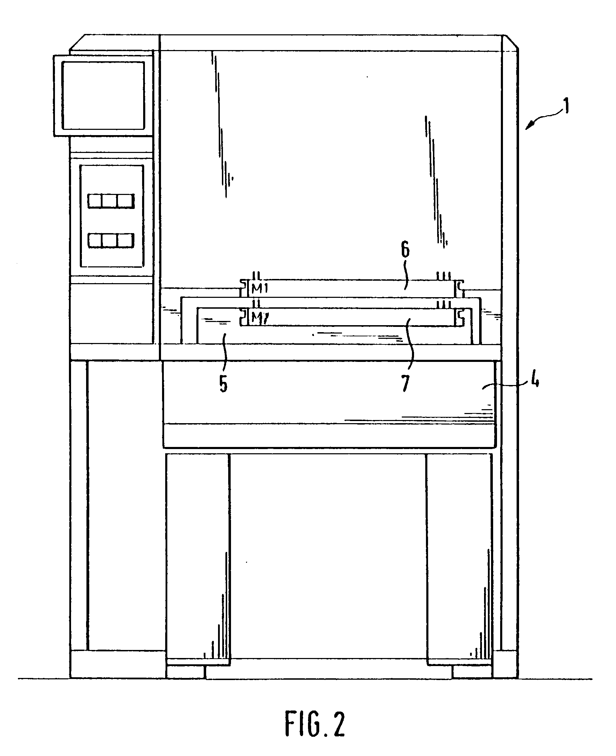

Fig. 2 zeigt die Situation der Fig. 1 in prinzipieller Darstellung von vorne, also in Blickrichtung entgegen der Y-Achse. Man sicht die Leiterplatten-Bohrmaschine 1 von vorne mit dem vordersten Werkzeugmagazin M1 auf der Vorratsebene 6A der Magazine 6 und dem aktuellen Werkzeugmagazin 7 am vorderen Rand der Werkstück-Spannplatte 5 bzw. des Y-Schlittens. Die vom Gehäuse 3 abgedeckten Bohrspindeleinheit(en) der LP-Bohrmaschine ist (sind) in Fig. 2 wiederum nicht gezeigt.

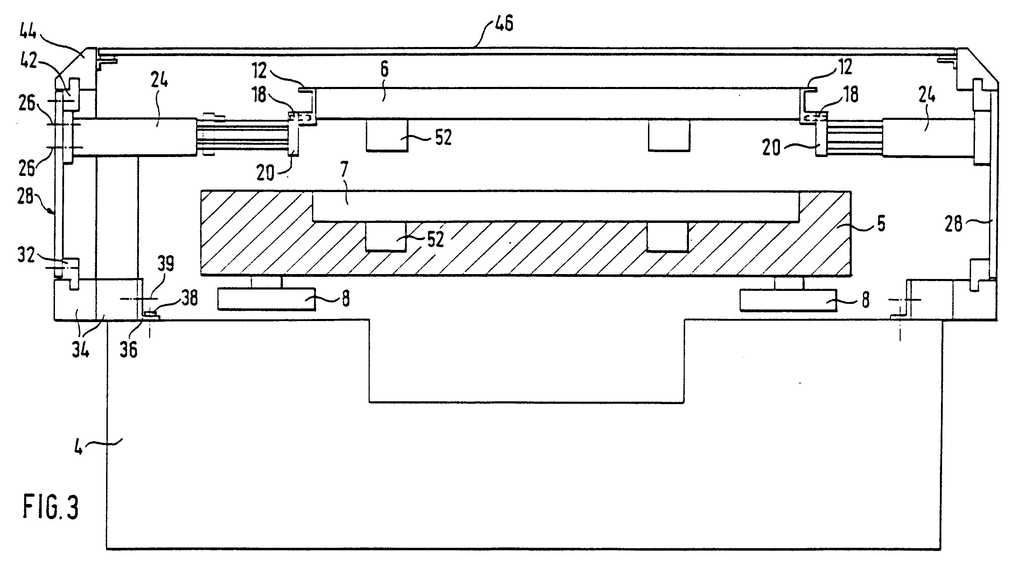

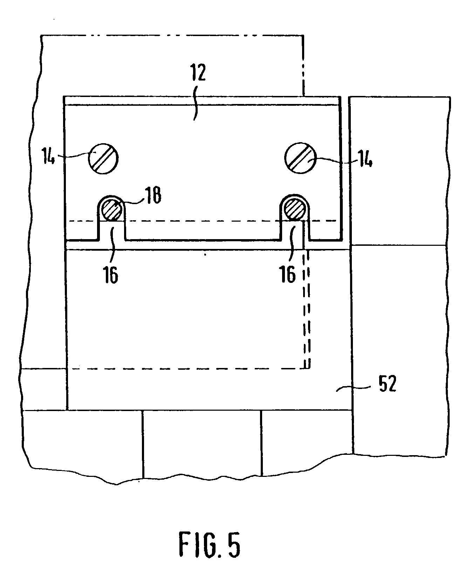

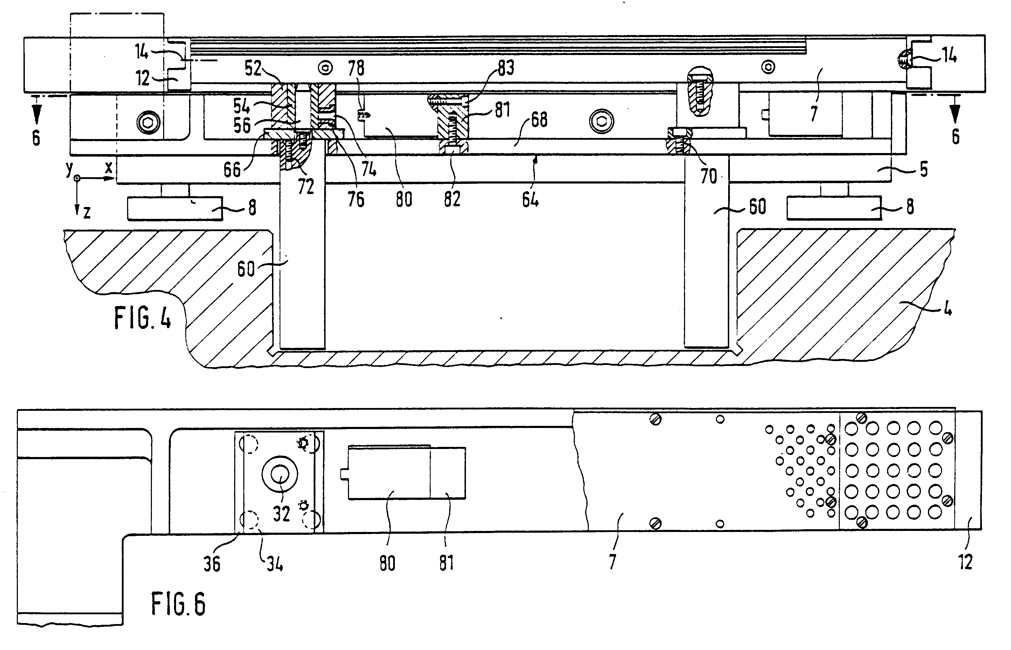

Fig. 3 zeigt das aktuelle Magazin 7 der Werkstück-Spannplatte 5 sowie ein Magazin von weiteren in der Vorratsebene 6A angeordneten Magazinen. Jedes der Magazine 6 ist an jeder ihrer parallel zur Längsrichtung des Bohrmaschinengehäuses (in Y-Richtung) verlaufenden Seite mit einer Griffleiste 12 versehen, die mit Schrauben 14 (siehe Fig. 4, 5) an dem jeweiligen Magazin befestigt sind. Jede Griffleiste 12 umfaßt jeweils zwei Nuten 16 (siehe Fig. 5) zur Aufnahme von Stiften 18, so daß jedes Magazin M1 bis M6 in der Vorratsebene auf insgesamt vier horizontal in X-Richtung verlaufenden Stiften 18 gelagert wird. Jeweils zwei Stifte 18 sind an einem Druckstück 20 angebracht, das mit einem Kolben eines Pneumatik-Zylinders 24 verbunden ist. Dementsprechend sind in der Fig. 3 die beiden Druckstücke 20 und damit auch die Stifte 18 aus der in der Fig. 3 gezeigten Lage auswärts zurückfahrbar, so daß das obere Magazin 6 aus der Vorratsebene 6A in einer noch zu beschreibenden Weise nach unten in die Spanntisch-Ebene abgesenkt werden kann. Jeder der beiden Pneumatik-Zylinder 24 ist mittels Schrauben 26 an der jeweiligen Seitenwandung 28 befestigt, die an der Längsseite der Grundplatte 4 befestigt ist und ebenfalls in Y-Richtung verläuft. Jede Seitenwandung 28 ist an ihren unteren Ende mittels eines Verbindungsprofils 32 an einem Profil 34 festgeschraubt, das vorzugsweise aus Aluminium gebildet ist. Die Profile 34 sind wiederum mittels Befestigungselementen 36 und Schrauben 38, 39 an der Grundplatte 4 befestigt. Am oberen Ende jeder Seitenwandung 28 sind mittels Verbindungsprofilen 42 Winkelprofile 44 angebracht. Die an den beiden Seitenwandungen 28 angebrachten und parallel zu diesen verlaufenden Winkelprofile 44 halten eine Abdeckung 46 der Magazin-Anordnung und -Wechseleinrichtung.

Jedes Werkzeugmagazin 6, 7 umfaßt jeweils zwei Füße 52. Wie Fig. 4 zeigt, weist jeder Fuß 52 eine durchgehende Bohrung mit einer Buchse 54 auf, in die von unten ein Paßstift 56 hineinfahren kann, der auf den Kolbenstangen von zwei vorne beiderseits der Mitte am Werkstück-Spanntisch befestigten Hubzylindern 60 angebracht ist. Die insgesamt zwei Hubzylinder 60 dienen dazu, das Magazin 7 von der Werkstück-Spannplatte 5 auf einen freien Platz der Vorratsebene 6A anzuheben bzw. eines der neuen (weiteren) Magazine 6 zur Werkstück-Spannplatte 5 abzusenken. Die Befestigung der Pneumatik-Hubzylinder 60 am Y-Schlitten 64 erfolgt durch einen Flansch 66, der auf der Oberseite des Bodens 68 des Y-Schlittens 64 gelegen ist. Der Flansch 66 ist mittels einer Befestigungsschraube 70 am Boden 68 befestigt, während das Gehäuse des Hubzylinders 60 mittels einer Befestigungsschraube 72 am Flansch befestigt ist.

Zur Verriegelung eines Werkzeug-Magazins an der Werkstück-Spannplatte 5 bzw. am Y-Schlitten 64 weist jeder Fuß 52 weiterhin eine Bohrung 74 auf, die in radialer Richtung derselben, also in X-Richtung verläuft. In die Bohrung 74 ist eine Aufnahme 76 eingebracht, in die ein Kolben 78 eines pneumatisch betätigten Verriegelungszylinders 80 hineinfahren kann, um den Fuß 52 und somit auch das Magazin 7 gegen eine Vertikal-Bewegung desselben zu verriegeln. Dazu muß jeder Verriegelungszylinder 80 fest mit dem Y-Schlitten 64 verbunden sein. Dies erfolgt mit Hilfe eines Zwischenstücks 81, das ebenfalls auf der oberen Seite des Bodens 68 des Y-Schlittens 64 angeordnet ist und mittels einer Schraube 82 am Boden 68 befestigt ist. Der Verriegelungszylinder 80 ist wiederum mittels einer Schraube 83 an dem Zwischenstück 81 befestigt.

Vorzugsweise sind die Hubzylinder 60, die Verriegelungszylinder 80 und die Zylinder 24 als Druckluftzylinder ausgeführt, die mit einer zentralen Druckluftversorgung in Verbindung stehen.

Zur Steuerung der Magazinwechseleinrichtung sind an den Druckluftzylindern Sensoren nach dem Stand der Technik angeordnet, um die vorgesehenen Einfahr- und Ausfahrstellungen der Druckluftzylinder zu kontrollieren und anzusteuern. Dazu sind elektrische Leitungen von den Sensoren zur zentralen Steuerung vorgesehen.

Im folgenden wird die Funktionsweise der dargestellten Ausführungsform einer erfindungsgemäßen Magazin-Anordnung und -Wechseleinrichtung beschrieben:

Die in den Fig. 1 bis 5 dargestellte Einrichtung ermöglicht es, daß eines von mehreren in der Vorratsebene befindlichen Werkzeugmagazinen in eine Lage gebracht werden kann, in der es für den üblichen Werkzeugwechsel der LP-Bohrmaschine benötigt wird, und daß dieses dann 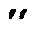 aktuelle*"* Magazin von dort wieder zurück in seine vorherige Lage in der Vorratsebene gebracht werden kann. Somit sind mehrere Werkzeugmagazine gegeneinander austauschbar, so daß die Anzahl der letztendlich zur Verfügung stehenden Werkzeuge fast beliebig erhöht werden kann. Dieser Austausch erfolgt automatisch und wird von der Steuereinheit der Leiterplatten-Bohrmaschine 1 gesteuert. Vor dem Beginn des Automatikbetriebs der Leiterplatten-Bohrmaschine 1 werden die Magazine M1 bis M7 manuell auf der Vorratsebene des Bezugzeichens 6 angeordnet. Jedes einzelne Magazin ist kodiert, um eine Falschplazierung desselben zu verhindern, wobei die Kodierung in bekannter Weise erfolgt. Diese Kodierung wird beispielsweise durch eine Formschluß-Verbindung erreicht. Durch die Kodierung wird sichergestellt, daß ein bestimmtes Magazin immer nur am zutreffenden Platz des Magazins angeordnet wird, was für die ordnungsgemäße Ansteuerung der Magazine von entscheidender Wichtigkeit ist.

Um ein in der Vorratsebene 6A gelegenes Werkzeugmagazin 6 aufzunehmen und es vor die Werkstück-Spannplatte 5 zu bringen, wenn sich dort noch kein aktuelles Magazin befindet, fährt der Y-Schlitten 64 in eine Y-Position, bei der sich die Paßzylinder 56 der Hubzylinder 60 in einer Lage genau unterhalb der Buchsen 54 der Füße 52 befinden, die mit dem von der Maschinensteurung ausgewählten Magazin in der Vorratsebene 6A verbunden sind. Dann fahren die Hubzylinder 60 nach oben aus, bis die Paßzylinder 56 vollständig in die Buchsen 54 eingefahren sind. Sodann wird das aufzunehmende Magazin an seinem Magazinplatz freigegeben, indem die Zylinder 24 einfahren und die Stifte 18 aus den Nuten 16 herausfahren. Daraufhin fahren die Hubzylinder 60 nach unten ein, so daß das aufgenommene Magazin abgesenkt wird. Anschließend wird das Magazin an seinen Füßen 52 mittels der Verriegelungszylinder 80 am Y-Schlitten 64 bzw. an der darauf angeordneten Werkstück-Spannplatte 5 verriegelt, indem die Verriegelungszylinder 80 ausfahren. In dieser Anordnung kann der Y-Schlitten 64 zusammen mit dem entsprechenden dann 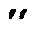 aktuellen*"* Werkzeug-Magazin verfahren werden, wie es zur Bearbeitung der Werkstücke bzw. für den Werkzeugaustausch zwischen dem aktuellen Magazin und der Bohrspindeleinheit erforderlich ist.

Um ein mit dem Y-Schlitten 64 verriegeltes aktuelles Werkzeugmagazin 7 wieder an den vorgesehenen Magazinplatz auf der Vorratsebene abzulegen, fährt der Y-Schlitten 64 so weit aus, bis das Werkzeugmagazin genau unterhalb seines (dann leeren) Magazinplatzes auf der Vorratsebene 6A gelegen ist. Daraufhin wird das aktuelle Werkzeug-Magazin durch Zurückfahren der Verriegelungszylinder 80 aus ihrer Verriegelungsstellung entriegelt. Die Hubzylinder 60 fahren dann nach oben aus, um das Werkzeugmagazin auf seinen vorgesehenen leeren Magazinplatz anzuheben. Wenn sich das Werkzeugmagazin auf der Vorratsebene 6A befindet, fahren die auf der Vorratsebene angeordneten Magazin-Haltezylinder 24 aus, so daß das Werkzeugmagazin auf den Stiften 18 abgelegt werden kann. Anschließend fahren die Hubzylinder 60 ein, so daß die Paßzylinder 56 vollständig aus der Buchse 54 herausfahren. Der Y-Schlitten 64 und die Hubzylinder 60 sind dann in der Lage, ein weiteres der auf der Vorratsebene gelegenen Werkzeugmagazine 6 aufzunehmen und in die Lage vor der Werkzeug-Spannplatte 5 zu bringen.

Entsprechende Sensoren in den Hubzylindern 60 und den Zylindern 24 sorgen dafür, daß diese bei der Aufnahme bzw. dem Ablegend der Werkzeugmagazine auf der entsprechenden Vorratsebene genau in der vorgesehenen Länge ausfahren, so daß beispielsweise bei der Verriegelung des Werkzeugmagazins mit dem Y-Schlitten 64 die Füsse 52 in genau die Lage gebracht werden, daß die Kolben 78 in die Bohrungen 74 einfahren können.

Die Steurung der Leiterplatten-Bohrmaschine 1 stellt sicher, daß die Hubzylinder 60 nicht ausfahren bzw. einfahren können, wenn die Verriegelungszylinder 80 verriegelt sind.

Durch die beschriebene Ausführungsform ist eine sehr einfache Abfolge von linearen Bewegungen möglich, um Werkzeugmagazine aufzunehmen und zur Werkstück-Spannplatte 5 zu bringen bzw. diese von dort zur Vorratsebene 6A zurückzubringen. Mit der beschriebenen bevorzugten Anordnung wird der Raum oberhalb der Werkstück-Spannplatte 5 zwischen der Tischvorderseite und der Bohrspindel für den Magazin-Vorrat genutzt, was im wesentlichen nur bei Leiterplatten-Bohrmaschinen möglich ist, weil diese nur einen sehr beschränkten Raumbedarf für die Werkstücke (zu bohrende Leiterplattenpakete) oberhalb der Werkstück-Spannplatte 5 haben.

Im folgenden werden verschiedene Alternativen zu der unter Bezugnahm auf die Ausführungsform der Fig. 1 - 6 erläuterten Magazin-Anordnung und -Wechseleinrichtung kurz angedeutet, und zwar unter Hinweis auf die Fig. 7:

Statt einer Vorratsebene 6A können auch zwei oder mehrere übereinander gelegene Vorratsebenen im Bereich zwischen der Tischvorderseite und der Bohrspindeleinheit im Gehäuse 3 oberhalb der Werkstück-Spannplatte 5 vorgesehen sein. Es ist dann ein entsprechender zusätzlicher Mechanismus vorzusehen, der den Zugriff auf ein Werkzeugmagazin freimacht, das sich auf einer der weiter oben liegenden Vorratsebenen befindet. Dies könnte z.B. mit einer entsprechenden Verschiebung der Werkzeugmagazine auf den unteren Ebenen erreicht werden. Dazu sind dann die Werkzeugmagazine auf den unterhalb der obersten Vorratsebene gelegenen Vorratsebenen verschieblich angeordnet.

Die Magazin-Bevorratung oberhalb der Werkstück-Spannplatte 5 könnte weiterhin auch mit einem Horizontalförderer oder auch mit einem um eine zentrale Achse drehbaren Magazin-Zylinder oder einer anderen Einrichtung (z.B. ein Kettenförderer) zur Aufnahme einer Mehrzahl von Magazinen erfolgen. Die Werkzeugmagazine sind dann beispielsweise auf entsprechenden Gestellen entlang eines Förderbandes oder entlang des Umfanges des Magazin-Zylinders angeordnet. In diesem Fall bringt die Einrichtung zur Magazin-Bevorratung das von den Hubzylindern 60 aufzunehmende neue Magazin mit Hilfe eines Motors und einer entsprechenden Steuerung zunächst in eine Lage, bei der die Paßzylinder 56 der Hubzylinder 60 bei der Aufnahme des Magazins in die Buchsen 54 des aufzunehmenden Magazins einfahren können (Magazin-Wechselposition). Daraufhin werden die Magazin-Haltezylinder 24 eingefahren, so daß dann das Magazin durch Einfahren der Hubzylinder 60 abgesenkt und mittels der Verriegelungszylinder 80 verriegelt werden kann.

Die Werkzeugmagazine können jedoch auch auf andere Weise bevorratet werden als in der beschriebenen Weise oberhalb der Werkstück-Spannplatte bzw. des Y-Schlittens. Beispielsweise könnte ein Vertikalförderer mit einer Anzahl von Magazinen an einer geeigneten Stelle vor oder seitwärts von der Leiterplatten-Bohrmaschine 1 angeordnet sein, also z. B. an der Vorderseite der Grundplatte 4. Zur Entnahme eines Werkzeugmagazins wird das zu entnehmende Magazin desselben auf eine Ebene hochgefahren, die der Ebene entspricht, auf der sich der Platz für das aktuelle. Werkzeugmagazin 7 vor der Werkstück-Spannplatte 5 befindet (siche Fig. 1). Anschließend erfolgt die Entnahme diese Werkzeugmagazins aus dem Magazin-Speicher (also dem Vertikalförderer) sowie das Einsetzen des Werkzeugmagazins auf den Platz vor der Werkstück-Spannplatte entsprechend den beschriebenen Vorgängen mit Hilfe von z.B. geradlinig wirkenden Verschiebe-Mechaniken.

In einer weiteren möglichen Ausführungsform befinden sich Werkzeugmagazine in vertikaler Aufreihung, d.h. die Vorratsebene 6A der Werkzeugmagazine 6 kann senkrecht zur X-Achse oder zur Y-Achse angeordnet sein. Zur Entnahme eines Werkzeugmagazins wird das entspechende ausgewählte Werkzeugmagazin in die zur Z-Achse senkrechte Ebene heruntergeklappt, die der Ebene des Werkzeugmagazins 7 vor der Werkzeug-Spannplatte 5 entspricht (siehe Fig. 1). Sodann fährt der Y-Schlitten 64 in eine Stellung, bei der sich die Paßzylinder 56 genau unterhalb der Buchsen 54 des entsprechenden Werkzeugmagazins befinden. Die weiteren Schritte erfolgen in der Reihenfolge, wie sie anhand der bevorzugten Ausführungsform unter Bezugnahme auf die Figuren 1 - 6 beschrieben wurden.

Die erfindungsgemäße Magazin-Wechseleinrichtung wurde anhand der in den Fig. 1, 2 dargestellten Leiterplatten-Bohr- und Fräsmaschine beschrieben. Die beschriebenen Prinzipien der erfindungsgemäßen Magazin-Anordnung und -Wechseleinrichtung lassen sich in entsprechender Weise auch auf anders gestaltete Leiterplatten-Bohr- und Fräsmaschinen übertragen.

### Bezugszeichenliste

- 1: Leiterplatten-Bohrmaschine
- 2: Grundgestell
- 3: Gehäuse
- 4: Grundplatte, z.B aus Granit
- 5: Werkstück-Spannplatte als Teil des Y-Schlittens
- 6: Werkzeugmagazine auf der Vorratsebene
- 6A: Vorratsebene
- 7: Werkzeugmagazin vor der Werkstück-Spannplatte
- 8: Luftlager des Y-Schlittens/der Werkstück-Spannplatte
- 12: Griffleiste des Werkzeugmagazins
- 14: Schrauben zur Befestigung der Griffleiste 12
- 16: Nuten an der Griffleiste 12
- 18: Stift
- 20: Druckstück
- 24: Magazin-Haltezylinder, pneumatisch
- 26: Schrauben
- 28: Seitenwandung
- 32: Verbindungsprofil
- 34: Profil
- 36: Befestigungselemente
- 38, 39: Schrauben
- 42: Verbindungsprofil
- 43: Winkelprofile
- 46: Abdeckung
- 52: Fuß
- 54: Buchse im Fuß 52
- 56: Paßstift bzw -zylinder
- 60: Hubzylinder
- 64: Y-Schlitten
- 66: Flansch
- 68: Boden des Y-Schlittens 64
- 70, 72: Befestigungsschraube
- 74: Bohrung in der Wandung des Fußes 52
- 76: Aufnahme
- 78: Kolben
- 80: Verriegelungszylinder

## Patentansprüche

1. Leiterplatten-Koordinatenbohrmaschine (1) mit
- einem Werkstück-Spanntisch (5),
- einer in Z-Richtung verfahrbaren Bohrspindel, wobei die Bohrspindel und der Werkstück-Spanntisch relativ zueinander in X-, Y- und Z-Richtung verfahrbar sind,
- einem Werkzeug-Wechselsystem, und
- wenigstens einem, austauschbaren Werkzeug-Speichermagazin (6), vorzugsweise an einem der Seitenränder des Werkstück-Spanntisches (5),
gekennzeichnet durch
a) eine Aufreihung von zusätzlichen Werkzeug-Speichermagazinen (6) oder Magazin-Speicherreihen in unmittelbarer Nähe des in eine Magazin-Wechselposition eingefahrenen Werkstück-Spanntisches (5), und
b) eine Vorrichtung zur Verschiebung des aktuellen Magazins (7) an der Werkstück-Spannplatte (5) in einen freien Platz der Magazin-Speicherreihe und zum Einfahren eines zusätzlichen neuen Magazins in die Magazinaufnahme (50, 74, 80) des Spanntisches.

2. Bohrmaschine nach Anspruch 1, dadurch gekennzeichnet, daß die Magazin-Speicherreihe oberhalb und vorzugsweise zumindest teilweise parallel zur Ebene des Werkstück-Aufspanntisches (5) verläuft.

3. Bohrmaschine nach den Ansprüchen 1 oder 2, dadurch gekennzeichnet, daß die Magazin-Speicherreihe mehrere Ebenen umfaßt, in denen die zusätzlichen Werkzeug-Magazine (6) angeordnet sind, wobei die Ebenen zueinander parallel verlaufen.

4. Bohrmaschine nach einem oder mehreren der voranstehenden Ansprüchen, dadurch gekennzeichnet, daß die Magazin-Speicherreihe einen Horizontalförderer umfaßt, wobei die Längsseite der Magazine in dem Horizontalförderer parallel zum aktuellen Magazin der Bohr- und Fräsmaschine verlaufen.

5. Bohrmaschine nach einem oder mehreren der voranstehenden Ansprüche, dadurch gekennzeichnet, daß die Magazin-Speicherreihe als Vertikalförderer ausgebildet ist.

6. Bohrmaschine nach Anspruch 5, dadurch gekennzeichnet, daß die Längsseite der Magazine in dem Vertikalförderer parallel zum aktuellen Magazin der Bohr- und Fräsmaschine verlaufen.

7. Bohrmaschine nach einem oder mehreren der voranstehenden Ansprüche, dadurch gekennzeichnet, daß die Magazin-Speicherreihe als Revolver-Magazin ausgebildet ist.

8. Bohrmaschine nach Anspruch 7, dadurch gekennzeichnet, daß die Drehachse des Revolver-Magazins und die darin angeordneten Magazine parallel zum aktuellen Magazin an der Leiterplatten-Bohr- und Fräsmaschine verlaufen.

9. Bohrmaschine nach Anspruch 7, dadurch gekennzeichnet, daß die Drehachse des Magazin-Bevorratungszylinders transversal zur Y-Richtung der Leiterplatten-Bohr- und Fräsmaschine verläuft.

10. Bohrmaschine nach einem oder mehreren der voranstehenden Ansprüche, dadurch gekennzeichnet, daß die Magazin-Speicherreihe vor der Vorderseite der Leiterplatten-Bohr- und Fräsmaschine angeordnet ist.

11. Bohrmaschine nach einem oder mehreren der voranstehenden Ansprüche, dadurch gekennzeichnet, daß die Magazin-Speicherreihe seitlich neben der Leiterplatten-Bohr- und Fräsmaschine angeordnet ist.

12. Bohrmaschine nach einem oder mehreren der voranstehenden Ansprüche, dadurch gekennzeichnet, daß jedes Werkzeugmagazin (6, 7) an jeder ihrer Breitseiten Griffleisten (12) mit Nuten (16) zur Aufnahme durch Druckstücke von Pneumatikzylindern (24) aufweist, die an einer Seitenwandung (28) der Werkzeugwechseleinrichtung angeordnet sind.

13. Bohrmaschine nach einem oder mehreren der voranstehenden Ansprüche, dadurch gekennzeichnet, daß jedes Werkzeugmagazin (6, 7) ein oder mehrere Füße (52) mit einer Bohrung aufweist, in die jeweils ein am Kolben eines Hubzylinders (60) angeordneter Paßzylinder (56) einfährt, um das zu entnehmende Werkzeugmagazin (6) auf der entsprechenden Vorratsebene aufzunehmen und auf eine Ebene abzusenken, die der Ebene entspricht, in der sich das Werkzeugmagazin im Laufe eines Arbeitszyklusses vor der Werkstück-Spannplatte (5) befindet.

14. Bohrmaschine nach einem oder mehreren der voranstehenden Ansprüche, dadurch gekennzeichnet, daß jeder Fuß (52) eine Bohrung (74) mit einer darin angeordneten Aufnahme (76) aufweist, in die zur Verriegelung des Werkzeugmagazins (6, 7) ein Kolben (78) eines Verriegelungszylinders (80) einfahren kann, wobei der Verriegelungszylinder (80) an der Oberseite eines Bodens (68) des Y-Schlittens (64) befestigt ist.

15. Bohrmaschine nach einem oder mehreren der voranstehenden Ansprüche, dadurch gekennzeichnet, daß für jedes auf der Vorratsebene anzuordnende Werkzeugmagazin (6) zwei an jeder der sich gegenüberliegenden Innenseiten der Seitenwandung (28) befestigte Magazin-Haltezylinder (24) vorgesehen sind, deren Kolben mit jeweils einem Druckstück (20) und zwei daran angeordneten Stiften (18) versehen ist, auf denen die Griffleisten (12) in der ausgefahrenen Stellung der Zylinder (24) aufliegen.

16. Bohrmaschine nach einem oder mehreren der voranstehenden Ansprüche, dadurch gekennzeichnet, daß die bevorrateten Werkzeugmagazine in einer von der Ebene des Aufspanntisches (5) aus um 90 Grad hochgeklappten Stellung an der Seite und oberhalb der Granit-Grundplatte (4) angeordnet sind.

17. Verfahren zum Zuführen eines bevorrateten Werkzeugmagazins zur Entnahme von Bohr- und Fräswerkzeugen durch eine Bohrspindeleinheit einer Leiterplatten-Bohrmaschine, das folgende Schritte umfaßt:
a) Verfahren des Y-Schlittens (64) in Y-Richtung in eine Position, bis die Hubzylinder (60) des Y-Schlittens (64) sich in einer Position genau unterhalb der Füße (52) des zu entnehmenden Werkzeugmagazins befinden,
b) Ausfahren des Hubzylinders (60), bis der Paßzylinder (56) des Hubzylinders (60) in eine vorgesehene relative Lage in die Buchse (54) des Fußes (52) eingefahren ist,
c) Einfahren der Zylinder (24), um das Werkzeugmagazin freizugeben,
d) Absenken des zu entnehmenden Werkzeugmagazins durch Einfahren des Hubzylinders (60),
e) Verriegeln des Werkzeugmagazins (7) durch Ausfahren der Verriegelungszylinder (80),
wobei das Ablegen eines Werkzeugmagazins in eine Bevorratungsposition in umgekehrter Reihenfolge abläuft.
